# EUROPEAN PATENT APPLICATION

(11) **EP 1 740 031 A2**
(43) Date of publication of application: **03.01.2007**
(21) Application number: 06001864.5
(22) Date of filing: 30.01.2006
(51) Int. Cl.: H05K 5/02, G06K 19/077

(54) **Housing of a memory card capable of containing a plurality of memory chips**

(30) Priority: 15.06.2005 US 595205 P
(71) Applicant: A-DATA Technology Co., Ltd., Chung Ho City T'ai pei (TW)
(72) Inventor: Chuang, Min-Chou, Chia-Yi Hsien (TW)
(74) Representative: Weber, Joachim

(57) **Abstract**

A housing (300) of a memory card (200) includes an upper cover (210) and a lower cover (220). An angle between a largest inner plane (214) of the upper cover (210) and a largest outer plane (216) of the upper cover (210) is between 0.3 and 1 degree. An angle between a largest inner plane (224) of the lower cover (220) and a largest outer plane (226) of the lower cover (220) is between 0.3 and 1 degree. Therefore, the lower cover (220) can be joined with the upper cover (210) for containing a plurality of memory chips (232,236).

## Description

The present invention relates to a housing of a memory card according to the pre-characterizing clause of claim 1.

Various types of memory cards are developed for data storage. Presently, the most common memory cards are Compact Flash (CF) cards, Secure Digital (SD) cards, Multimedia cards (MMC), and the recently unveiled MiniSD and RSMMC (All Trademarks of their respective owners).

This in mind, the present invention aims at providing a housing of a memory card that is capable of containing a plurality of memory chips.

This is achieved by a housing of a memory card according to claim 1. The dependent claims pertain to corresponding further developments and improvements.

As will be seen more clearly from the detailed description following below, the claimed housing of a memory card is capable of containing a plurality of memory chips while still meeting the dimensions of Secure Digital cards as set forth in the related specification. Therefore, the Secure Digital card 200 of the present invention possesses higher memory capacity and data transmission speed compared to the prior art.

In the following, the invention is further illustrated by way of example, taking reference to the accompanying drawings. Thereof:
Fig.1 is an exploded view of a Secure Digital card of the prior art,
Fig.2 is a diagram showing the Secure Digital card of Fig.1 from another view angle,
Fig. 3 is a lateral exploded view of the Secure Digital card shown in Fig.1,
Fig.4 is a diagram showing the Secure Digital card of Fig. 1 having one additional memory chip on the printed circuit board,
Fig. 5 is a diagram showing a standard dimension of a Secure Digital card of the prior art,
Fig.6 is an exploded view of a Secure Digital card of the present invention,
Fig.7 is a diagram showing the Secure Digital card of Fig. 6 from another view angle,
Fig. 8 is a lateral exploded view of the Secure Digital card shown in Fig.6, and
Fig.9 is a cross-sectional view of the housing of the Secure Digital card shown in Fig.6.

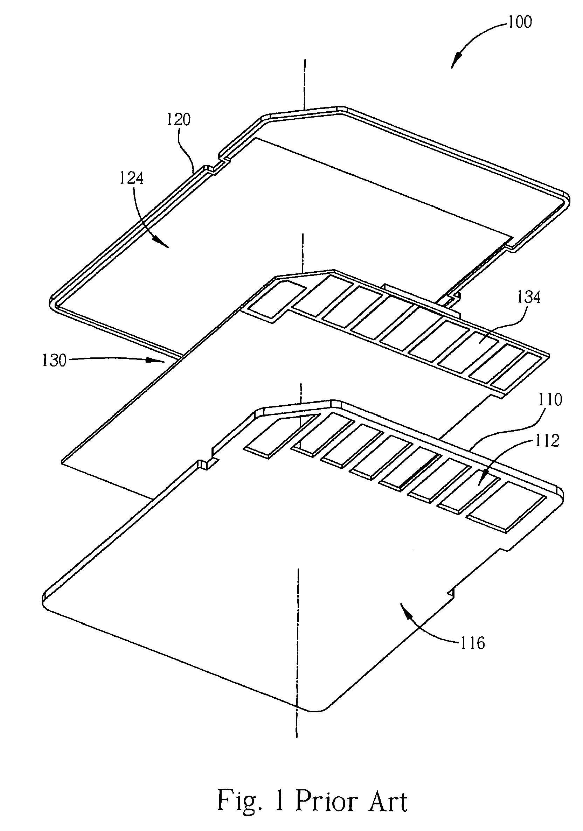

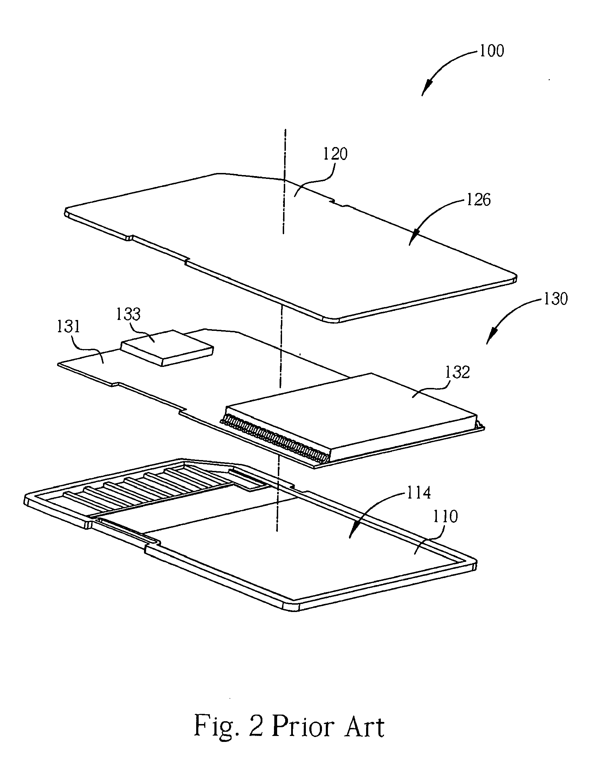

Please refer to Fig. 1 and Fig.2. Fig. 1 is an exploded view of a Secure Digital card 100 of the prior art, Fig.2 shows the Secure Digital card 100 of Fig.1 from another view angle. The Secure Digital card 100 comprises an upper cover 110, a lower cover 120, and a printed circuit board 130. The printed circuit board 130 comprises a substrate plate 131, a memory chip 132 (flash memory chip), and a plurality of contact pad surfaces 134 electrically connected to the memory chip 132. The upper cover 110 comprises a plurality of openings 112 corresponding to the plurality of contact pad surfaces 134, such that the contact pad surfaces 134 are capable of electrically connecting the memory chip 132 to an electronic device (such as a digital camera) for accessing data. The Secure Digital card 100 further comprises a controller unit 233 fixed on the substrate plate 131 for controlling data accessing between the electronic device and the memory chip 132.

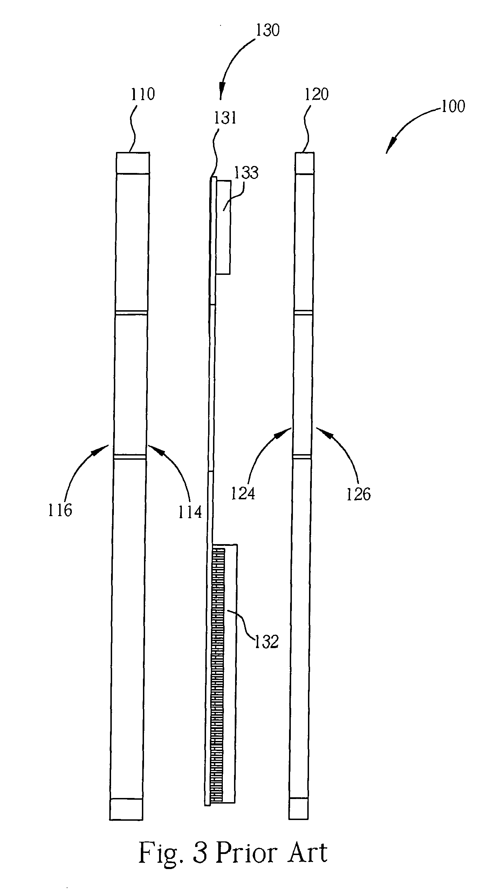

Please refer to Fig.3, and refer to Fig. 1 and Fig. 2 as well. Fig.3 is a lateral exploded view of the Secure Digital card 100 shown in Fig.1. In the prior art, a largest inner plane 114 of the upper cover 110 is parallel to a largest outer plane 116 of the upper cover 110, and a largest inner plane 124 of the lower cover 120 is parallel to a largest outer plane 126 of the lower cover 120. Therefore, the lower cover 120 is capable of being joined with the upper cover 110 for flatly accommodating the printed circuit board 130 in between.

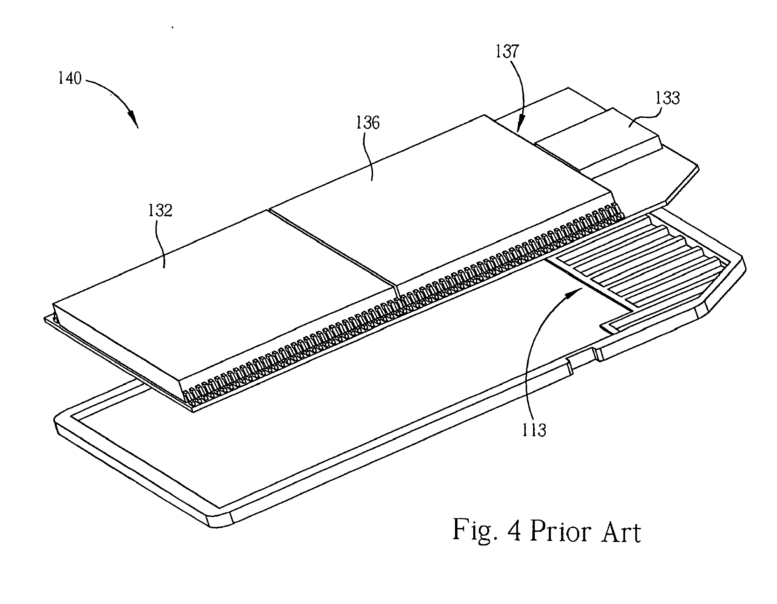

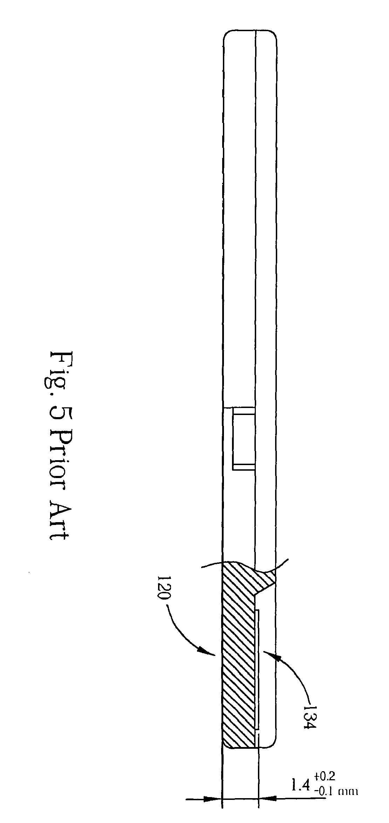

Any memory chip has its standard packaging size. As shown in Fig.4, if adding one more memory chip 136 on the printed circuit 140 in order to increase memory capacity and data transmission speed of the Secure Digital card 100, the edge 137 of the memory chip 136 will be over the edge 113 of the openings 112. This is because the dimensions of the Secure Digital card 100 must meet a standard specification. As shown in Fig.5, the standard thickness, which is from the top of the contact pad surface 134 to the bottom of the lower cover 120, is between 1.30 mm and 1.60 mm. Hence, if the edge 137 of the memory chip 136 is over the edge 113 of the openings 112, the printed circuit board 140 will interfere with the housing (that is the upper cover 110 and the lower cover 120) of the Secure Digital card 100, and cause the thickness, which is from the top of the contact pad surface 134 to the bottom of the lower cover 120, to deviate from the specification. Therefore, the housing of the Secure Digital card 100 of the prior art cannot contain a plurality of memory chips.

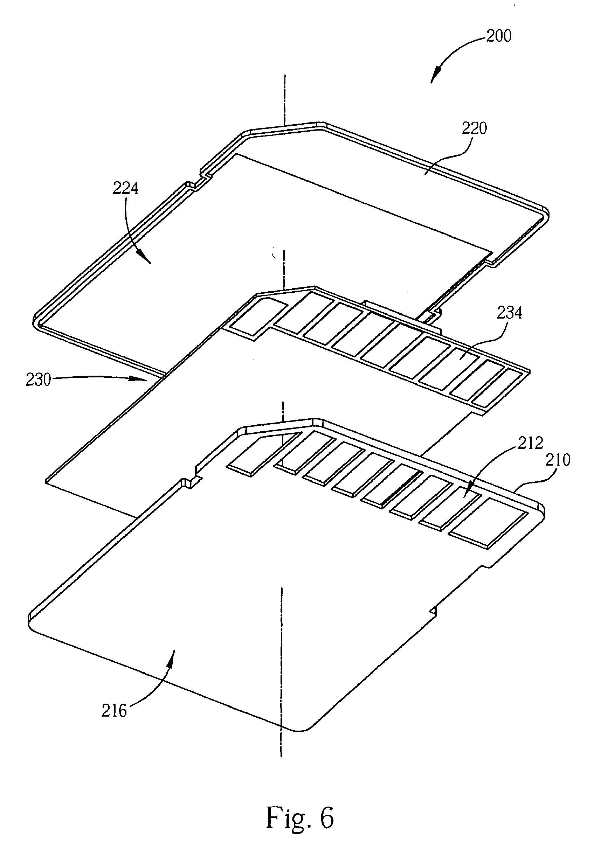

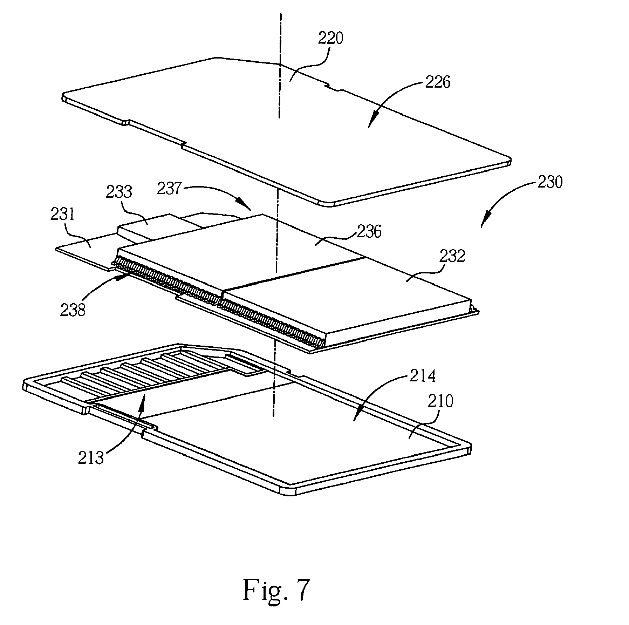

Please refer to Fig. 6 and Fig.7. Fig.6 is an exploded view of a Secure Digital card 200 of the present invention, Fig.7 shows the Secure Digital card 200 of Fig.6 from another view angle. The Secure Digital card 200 of the present invention comprises an upper cover 210, a lower cover 220, and a printed circuit board 230. The printed circuit board 230 comprises a substrate plate 231, two memory chips 232, 236, and a plurality of contact pad surfaces 234 electrically connected to the memory chips 232, 236. The upper cover 210 comprises a plurality of openings 212 corresponding to the plurality of contact pad surfaces 234, such that the contact pad surfaces 234 are capable of electrically connecting the memory chips 232, 236 to an electronic device for accessing data directly or via controller unit 233. The Secure Digital card 200 further comprises a controller unit 233 fixed on the substrate plate 231 for controlling data accessing between the electronic device and the memory chip 232, 236.

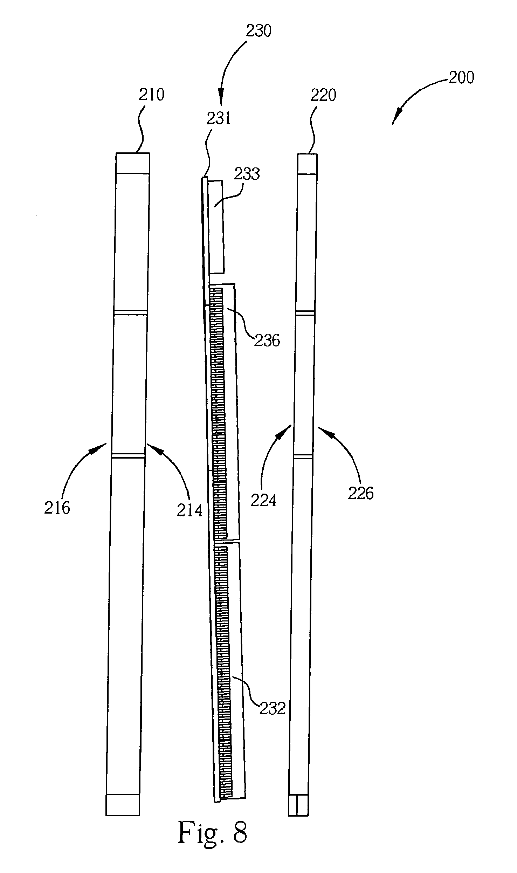

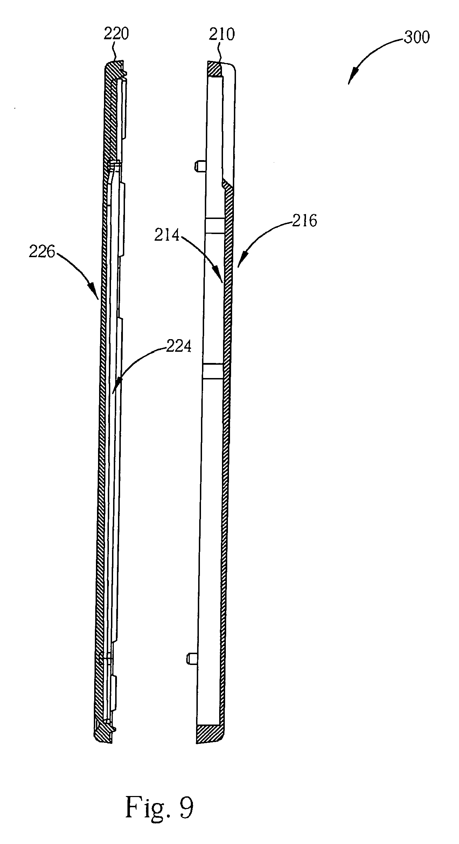

Please refer to Fig.8 and Fig.9, and refer to Fig.6 and Fig.7 as well. Fig.8 is a lateral exploded view of the Secure Digital card 200 shown in Fig. 6, and Fig. 9 is a cross-sectional view of a housing 300 of the Secure Digital card 200 shown in Fig.6. Different from the Secure Digital card 100 of the prior art, the angle between a largest inner plane 214 of the upper cover 210 and a largest outer plane 216 of the upper cover 210 is between 0.3 and 1 degree, accordingly, the angle between a largest inner plane 224 of the lower cover 220 and a largest outer plane 226 of the lower cover 220 is also between 0.3 and 1 degree. The angle of the upper cover 210 is corresponding to the angle of the lower cover 220, and therefore, the lower cover 220 is capable of being joined with the upper cover 210 for obliquely accommodating the printed circuit board 230 in between.

Because the printed circuit board 230 is obliquely accommodated between the upper cover 210 and the lower cover 220 thereby increasing the space between the upper cover 210 and the lower cover 220, especially in the thickness dimension, an edge 237 of the memory chip 236 will not be over an edge 213 of the openings 212. In other words, the thickness, which is from the top of the contact pad surface 234 to the bottom of the lower cover 220, does not deviate from that allowed by specification. For example, if the angle of the upper cover 210 and the angle of the lower cover 220 both are 0.67 degrees, based on the result of measurement, the edge 237 of the memory chip 236 is not over the edge 213 of the openings 212, and the thickness, which is from the top of the contact pad surface 234 to the bottom of the lower cover 220, is about 1.58 mm, which is in the range of the specification (1.30 mm - 1.60 mm). From the above, the housing 300 (that is the upper cover 210 and the lower cover 220) of the Secure Digital card of the present invention is capable of containing a plurality of memory chips.

In addition, one or more pin (s) 238 of the memory chip 236 closest to the plurality of contact pad surfaces 234 is usually a null pin. Therefore, in the present invention, the pin(s) closest to the plurality of contact pad surfaces 234 is not connected to the printed circuit board 230 in order to decrease the thickness of the printed circuit board 230 at the side near the contact pad surfaces 234, and thus increase tolerance in the thickness dimension. In the above preferred embodiment, both the upper cover 210 and the lower cover 220 have an angle between the largest inner and outer planes. However, in other preferred embodiments of the present invention, one cover can have an angle between the largest inner and outer planes with the other cover's largest inner and outer planes parallel to each other, as long as one cover has an angle between the largest inner and outer planes for increasing space inside the housing in the thickness dimension. For example, the upper cover 210 has an angle between the largest inner and outer planes 214, 216, and the lower cover's 220 largest inner and outer planes 224, 226 are parallel to each other. Or, the lower cover 220 has an angle between the largest inner and outer planes 224, 226, and the upper cover's 210 largest inner and outer planes 214, 216 are parallel to each other.

Summarizing the above, the present invention changes the interior structure of the housing 300 of the Secure Digital card 200 for increasing space between the upper cover 210 and the lower cover, especially in the thickness dimension. Therefore, the housing 300 of the Secure Digital card 200 is capable of containing a plurality of memory chips 232, 236 without causing the edge 237 of the memory chip 236 to interfere with the edge 213 of the openings 212. This means that the thickness from the top of the contact pad surface 234 to the bottom of the lower cover 220 will be within the specification (1.30 mm ~ 1.60 mm).

In contrast to the prior art, the present invention is capable of containing a plurality of memory chips while still meeting the dimensions of Secure Digital cards as set forth in the related specification. Therefore, the Secure Digital card 200 of the present invention possesses higher memory capacity and data transmission speed compared to the prior art.

## Claims

1. A housing (300) of a memory card (200) comprising:
an upper cover (210); and
a lower cover (220);
**characterized in**
**that** an angle between a largest inner plane (214) of the upper cover (210) and a largest outer plane (216) of the upper cover (210)is between 0.3 and 1 degree; and
**that** an angle between a largest inner plane (224) of the lower cover (220) and a largest outer plane (226) of the lower cover (220) is between 0.3 and 1 degree, the lower cover (220) capable of being joined with the upper cover (210) for containing a plurality of memory chips (232,236).

2. A memory card (200) comprising:
an upper cover (210);
a lower cover (220); and
a printed circuit board (230) accommodated between the upper cover (210) and the lower cover (220), the printed circuit board (230) comprising:
a substrate plate (231);
a first memory chip (236) fixed on the substrate plate (231); and
a plurality of contact pad surfaces (234) electrically connected to the first memory chip (236);
**characterized in**
**that** the printed circuit board (230) further comprises a second memory chip (232) fixed on the substrate plate (231) and electrically connected to the plurality of contact pad surfaces (234);
**that** an angle between a largest inner plane (214) of the upper cover (210) and a largest outer plane (216) of the upper cover (210) is between 0.3 and 1 degree; and
**that** an angle between a largest inner plane (224) of the lower cover (220) and a largest outer plane (226) of the lower cover (220) is between 0.3 and 1 degree.

3. The memory card of claim 2 **characterized in that** a null pin of the first memory chip (236) is not welded onto the substrate plate (231).

4. A housing (300) of a memory card (200) comprising:
an upper cover (210); and
a lower cover (220);
**characterized in**
**that** an angle between a largest inner plane (214) of the upper cover (210) and a largest outer plane (216) of the upper cover (210) is equal to a specific angle greater than 0 degrees; and
**that** an angle between a largest inner plane (224) of the lower cover (220) and a largest outer plane (226) of the lower cover (220) is equal to the specific angle, the lower cover (220) capable of being joined with the upper cover (210) for containing a plurality of memory chips (232,236).

5. A memory card (200) comprising:
an upper cover (210);
a lower cover (220); and
a printed circuit board (230) accommodated between the upper cover (210) and the lower cover (220), the printed circuit board (230) comprising:
a substrate plate (231);
a first memory chip (236) fixed on the substrate plate (231) ; and
a plurality of contact pad surfaces (234) electrically connected to the first memory chip (236);
**characterized in**
**that** the printed circuit board (230) further comprises a second memory chip (232) fixed on the substrate plate (231) and electrically connected to the plurality of contact pad surfaces (234);
**that** an angle between a largest inner plane (214) of the upper cover (210) and a largest outer plane (216) of the upper cover (210) is equal to a specific angle greater than 0 degrees; and
**that** an angle between a largest inner plane (224) of the lower cover (220) and a largest outer plane (226) of the lower cover (220) is equal to the specific angle.

6. The memory card of claim 5 **characterized in that** a null pin of the first memory chip (236) is not welded onto the substrate plate (231).

7. The memory card of claim 3 or 6 **characterized in that** the null pin is a pin (238) of the first memory chip (236) closest to the plurality of contact pad surfaces (234).

8. A housing (300) of a memory card (200) comprising:
a first cover (210); and
a second cover (220);
**characterized in**
**that** an angle between a largest inner plane (214) of the first cover (210) and a largest outer plane (216) of the first cover (210) is between 0.3 and 1 degree; and
**that** the second cover (220) capable of being joined with the first cover (210) for containing a plurality of memory chips (232,236).
